# EUROPÄISCHE PATENTANMELDUNG

(11) **EP 3 726 511 A1**
(43) Veröffentlichungstag der Anmeldung: **21.10.2020**
(21) Anmeldenummer: 20170040.8
(22) Anmeldetag: 17.04.2020
(51) Int. Cl.: G09F 27/00, G09F 9/37, G09F 9/33, G09F 21/10

(54) **ENERGIEAUTARKE DISPLAYEINHEIT**

(30) Priorität: 18.04.2019 DE 102019110353
(71) Anmelder: Lufthansa Technik AG, 22335 Hamburg (DE)
(72) Erfinder: Woll, Philip, 22763 Hamburg (DE)
(74) Vertreter: Glawe, Delfs, Moll

(57) **Zusammenfassung**

Die Erfindung betrifft eine energieautarke Displayeinheit (1) für die Kabine von Fahrzeugen, insbesondere von Flugzeugen.

Die energieautarke Displayeinheit (1) umfasst ein Displayelement (10) zur Anzeige von Informationen auf einer Displayfläche (11), ein Energiespeicher (20), eine Steuerungseinheit (30) und ein Photovoltaikelement, wobei das Photovoltaikelement zum Aufladen des Energiespeicher (20) mit dieser verbunden ist, der Energiespeicher (20) zur Energieversorgung mit dem Displayelement (10) und der Steuerungseinheit (30) verbunden ist und die Steuerungseinheit (20) zur Steuerung des Displayelementes (11) und der auf dessen Displayfläche (11) angezeigten Informationen ausgebildet ist. Das Photovoltaikelement ist eine sich über die gesamte Displayfläche (11) des Displayelements (10) erstreckende durchsichtige Solarzelle (40), womit das Photovoltaikelement eine erste Lage auf dem Displayelement (10) ist

## Beschreibung

Die Erfindung betrifft eine energieautarke Displayeinheit für die Kabine von Fahrzeugen, insbesondere von Flugzeugen.

In der Kabine von Fahrzeugen, wie bspw. von Flugzeugen, insbesondere Verkehrsflugzeugen, werden den Passagieren Informationen auf unterschiedliche Weise zur Verfügung gestellt.

Vermeintlich statische Informationen sind dabei regelmäßig auf Folien gedruckt und entweder in dafür vorgesehene Rahmen und Halterungen in der Flugzeugkabine eingesetzt oder unmittelbar auf die Kabinenwand oder in der Kabine vorgesehene Ausstattungen aufgeklebt sind. Für sich im Laufe eines Fluges ändernde Informationen sind Bildschirme und wahlweise beleuchtete Hinweisleuchten vorgesehen, die über die Kabine verteilt und an die jeweils auszugebenen Informationen (bspw. hinsichtlich ihrer Größe oder die Farbwiedergabeeigenschaften) angepasst sind. Schlussendlich können bei modernen Verkehrsflugzeugen noch für jeden Passagiersitz individuelle Monitore vorgesehen sein, auf denen neben allgemeinen und zentral gesteuerten Informationen auch das In-flight-Entertainment angeboten werden kann.

Das Aufdrucken von Informationen auf Folien ist nachteilig, da es praktisch auf statische Informationen beschränkt ist. Eine Veränderung der auf einer Folie wiedergegebenen Information würde nämlich einen vollständigen Austausch der Folie bedeuten, was insbesondere bei aufgeklebten Folien sehr aufwendig ist.

Bildschirme und Hinweisleuchten haben den Nachteil, dass - selbst wenn sie nur sich selten ändernde Inhalte anzeigen - aufwendig an die Stromversorgung des Flugzeuges angeschlossen werden müssen. Die Position der Bildschirme innerhalb der Flugzeugkabine ist dadurch in der Regel nicht frei wählbar.

Der Erfindung liegt die Aufgabe zugrunde eine Displayeinheit für die Kabine von Flugzeugen zu schaffen, bei der die aus dem Stand bekannten Nachteile nicht mehr oder nur noch in vermindertem Umfang auftreten.

Gelöst wird diese Aufgabe durch eine Displayeinheit gemäß dem Hauptanspruch. Vorteilhafte Weiterbildungen sind Gegenstand der abhängigen Ansprüche.

Demnach betrifft die Erfindung eine energieautarke Displayeinheit für die Kabine von Fahrzeugen umfassend ein Displayelement zur Anzeige von Informationen auf einer Displayfläche, ein Energiespeicher, eine Steuerungseinheit und ein Photovoltaikelement, wobei das Photovoltaikelement zum Aufladen des Energiespeicher mit dieser verbunden ist, der Energiespeicher zur Energieversorgung mit dem Displayelement und der Steuerungseinheit verbunden ist und die Steuerungseinheit zur Steuerung des Displayelementes und der auf dessen Displayfläche angezeigten Informationen ausgebildet ist, und wobei das Photovoltaikelement eine sich über die gesamte Displayfläche des Displayelements erstreckende durchsichtige Solarzelle ist, womit das Photovoltaikelement eine erste Lage auf dem Displayelement ist.

Zunächst werden einige in Zusammenhang mit der Erfindung verwendete Begriffe erläutert.

Eine Einheit gilt dann als "energieautark" im Sinne der Erfindung, wenn zu deren elektrischer Energieversorgung ausschließlich an der Einheit lokal verfügbare Energieformen genutzt werden und auf eine externe Versorgung mit elektrischer Energie und dafür erforderliche Leitungen vollständig verzichtet wird. Bei den "lokal verfügbare Energieformen" handelt es sich insbesondere um solche Energieformen, die grundsätzlich bzw. aus anderen Gründen als speziell zum Zwecke der Energieversorgung auf die Einheit einwirken, wie bspw. Licht zur Beleuchtung der Umgebung.

Mit "Displayfläche" ist diejenige Fläche eines Displays bezeichnet, auf der die anzuzeigenden Informationen visuell wahrnehmbar ausgegeben werden.

Bei einer "Lage" handelt es sich um ein Element, dessen Dicke um Größenordnungen kleiner ist als seine Länge und Breite. Eine Einheit weist einen "Mehrlagen-Aufbau" auf, wenn mehrere identische oder unterschiedliche Lagen zu einer Einheit geschichtet zusammengefügt sind, wobei die Dicke der Einheit regelmäßig ebenfalls um Größenordnungen kleiner ist als deren Länge und Breite.

Die erfindungsgemäße Displayeinheit ist energieautark und muss daher nicht an die bordeigene Stromversorgung eines Fahrzeugs angeschlossen werden. Die Energieautarkie wird über eine Solarzelle erreicht, die transparent ist und sich über die gesamte Displayfläche des Displayelementes erstreckt. Dies bietet den Vorteil, dass die Größe der Displayeinheit im Wesentlichen durch die Größe der Displayfläche bestimmt ist und insbesondere keine zusätzlichen Flächen zur Gewinnung von elektrischer Energie, bspw. durch neben der Displayfläche angeordnete Solarzellen, erforderlich sind. Die für die Energieerzeugung erforderliche Strahlungsenergie steht regelmäßig in Form von einfallendem Sonnenlicht oder künstlicher Kabinenbeleuchtung zur Verfügung. Da die Displayfläche einer Displayeinheit für ein Fahrzeug grundsätzlich zum Kabineninnenraum hin und einsehbar ausgerichtet ist, ist sichergestellt, dass diese Strahlungsenergie auf die Solarzelle auftrifft und auch tatsächlich in elektrische Energie zum Betrieb der Displayeinheit gewandelt werden kann. Bei der transparenten Solarzelle kann es sich um eine transparente organische Solarzelle handeln.

Damit die Displayeinheit auch bei zeitweise ausbleibender Beleuchtung - bspw. in der Nacht bei ausgeschalteter Kabinenbeleuchtung oder bei einer kurzzeitigen Abschattung durch einen Passagier - und somit bei fehlender, zur Umwandlung in elektrische Energie geeigneter Strahlungsenergie weiterbetrieben werden kann, umfasst die Displayeinheit einen Energiespeicher, der durch die Solarzelle geladen und in entsprechenden Dunkelphasen Energie zum Weiterbetrieb der Displayeinheit zur Verfügung stellen kann. Zur Steuerung der Displayeinheit und insbesondere der auf der Displayfläche dargestellten Information ist eine Steuerungseinheit vorgesehen.

Auch wenn sich die Solarzelle über die gesamte Displayfläche erstreckt, ist die über die Solarzelle zu gewinnende elektrische Leistung begrenzt. Dies gilt umso mehr als die Solarzelle transparent ist, damit die auf der Displayfläche dargestellten Informationen weiterhin sichtbar sind, weswegen jedoch ein Teil der einfallenden Strahlungsenergie, insbesondere im sichtbaren Bereich, durch die Solarzelle hindurchtreten muss und nicht in elektrische Energie gewandelt werden kann. Um dennoch einen zuverlässigen Betrieb der Displayeinheit sicherzustellen, ist der Energieverbrauch insbesondere des Displayelements an die zur Verfügung stehende geringe elektrische Energie anzupassen. Es ist daher bevorzugt, wenn das ein E-Papier-Display oder ein OLED-Display ist.

Bei einem E-Papier-Display handelt es sich um eine passive, nichtleuchtende Anzeige, die in der Regel nur dann elektrische Energie verbraucht, wenn sich die anzuzeigenden Informationen, also der anzuzeigende Bildinhalt, ändert. Bei Nicht-Veränderung wird das angezeigte Bild über einen längeren Zeitraum (in der Regel mehrere Wochen) stabil und unverändert gehalten, ohne das dazu elektrische Energie erforderlich wäre. Die Steuerungseinheit kann dazu ausgebildet sein, das auf der Displayfläche anzuzeigende Bild nach einem vorgegebenen Zeitraum zu aktualisieren, auch wenn sich dessen Inhalt nicht geändert hat, um eine gewünschte Darstellung auf der Displayfläche gleichbleibend sicherzustellen. Ein E-Papier-Display ist besonders für die Wiedergabe von sich nur selten ändernden Informationen geeignet. Es kann zur monochromen oder farbigen Anzeige von Informationen ausgebildet sein.

Alternativ ist auch die Verwendung eines OLED-Displays als Displayelement möglich. Bei einem OLED-Display handelt es sich um ein selbstleuchtendes Display mit geringem Stromverbrauch im Betrieb. Dennoch wird - anders als bei E-Papier-Displays - bei der Anzeige von Information auf der Displayfläche durchgängig Energie verbraucht. Angesichts der geringen zur Verfügung stehenden Energie eignen sich erfindungsgemäße Displayeinheiten mit OLED-Displays besonders für die Anzeige von Informationen, von denen bekannt ist, dass sie nur zeitweise angezeigt werden müssen. Aufgrund ihrer selbstleuchtenden Eigenschaft lassen entsprechende Displayelemente mit OLED-Display insbesondere aber auch für Notfallsysteme verwendbar, bspw. als Notbeleuchtung oder Fluchtwegemarkierung, bei denen im Notfall die Energieversorgung durch den unmittelbar an der Displayeinheit angeordneten Energiespeicher erfolgt, der im Normalbetrieb bei ausgeschaltetem Display ausreichend durch die Solarzelle aufgeladen werden kann.

Die Solarzelle und/oder der Energiespeicher sind vorzugsweise so ausgelegt, dass über einen typischen Tageszyklus ausreichend Energie gewonnen und/oder gespeichert werden kann, dass der Betrieb der Displayeinheit über den gesamten Tag möglich ist, wobei vorzugsweise eine Änderung des Displayinhalts wenigstens einmal pro Stunde möglich ist. Letzteres ist insbesondere für die Ermittlung der erforderlichen Energiemenge bei E-Papier-Displays maßgeblich. Die von der Solarzelle erzeugbare Energiemenge ergibt sich aus den im Laufe eines Tages typischerweise im Innenraum der Kabine auftretenden Lichtverhältnissen und soll größer gleich sein der über den Tag erforderlichen Energie zum Betrieb der Displayeinheit.

Es ist bevorzugt, wenn der Energiespeicher und/oder die Steuerungseinheit jeweils als eine Lage oder zusammen als eine gemeinsame Lage eines Mehrlagen-Aufbaus der Displayeinheit ausgebildet sind. Indem auch diese beiden Elemente der Displayeinheit als Lagen eines Mehrlagen-Aufbaus ausgestaltet sind, lässt sich eine Displayeinheit mit geringer Dicke und ohne seitlich von der Displayfläche angeordnete größere Einfassung erreichen. Für die Ausgestaltung von Energiespeicher und Steuerungseinheit als Lage können diese wenigstens teilweise gedruckte Elektronikelemente umfassen.

Vorzugsweise ist die auf der von der Displayfläche abgewandten Seite äußerste Lage der Displayeinheit eine Montageschicht, die weiter vorzugsweise eine selbstklebende oder magnetisch wirkende Oberfläche aufweist. In anderen Worten soll die Displayeinheit auf ihrer Rückseite zur klebenden oder magnetischen Befestigung der Einheit ausgebildet sein. Mit einer entsprechenden Montageschicht lässt sich das Displayelement je nach Befestigungsmethode lösbar oder unlösbar befestigen.

Weiterhin bevorzugt ist es, wenn die auf der Seite der Displayfläche äußerste Lage der Displayeinheit eine transparente Schutzschicht zum Schutz der darunterliegenden Lagen vor Beschädigungen ist. Bspw. für den Fall, dass die als Lage ausgebildete Solarzelle kratzempfindlich ist, kann durch eine geeignete Schutzschicht eine Beschädigung der darunterliegenden Solarzellenlage wirksam verhindert werden.

Die Displayeinheit kann eine berührungsempfindliche Schicht zur Ermittlung einer Berührung der Displayfläche umfassen, sodass die Displayeinheit nicht ausschließlich zu Anzeige von Informationen, sondern auch zu Entgegennahme von Nutzerbefehlen ausgebildet ist. Eine berührungsempfindliche Displayeinheit kann bspw. zur Steuerung der Kabinenbeleuchtung oder einer Klimaanlage verwendet werden. Je nach verwendeter Technologie zur Erfassung von Berührungen ist die berührungsempfindliche Schicht transparent auszubilden, damit - sofern sie oberhalb der Displayfläche angeordnet ist - die auf der Displayfläche angezeigte Information grundsätzlich sichtbar ist. Erfordert die berührungsempfindliche Schicht mechanische Krafteinwirkung zur Detektion einer Berührung, sind die zwischen der berührungsempfindliche Schicht und der Außenseite der Displayeinheit auf der Seite der Displayfläche angeordneten Schichten derart auszubilden, dass die Detektion von Berührungen durch die berührungsempfindliche Schicht möglich ist. Bspw. können die einzelnen Schichten hierfür ausreichend elastisch verformbar ausgebildet werden.

Es ist bevorzugt, wenn die Displayeinheit als Ganzes biegsam ist, sich also in gewissen Grenzen elastisch verformen lässt. Eine solche Biegsamkeit ist vorteilhaft, um einen Typ von Displayeinheiten an verschiedenen Orten verwenden zu können, bspw. sowohl an ebenen als auch an gekrümmten Innenwänden einer Flugzeugkabine. Um die Biegsamkeit der Displayeinheit als Ganzes gewährleisten zu können, müssen sämtliche Lagen der Displayeinheit elastisch verformbar sein.

Weist die Displayeinheit einen Mehrlagen-Aufbau auf, sind die Lagen der Displayeinheit an dem umlaufenden Rand derart miteinander verbunden oder dort mit einem zusätzlichen Element versehen, dass - auch bei Vibrationen oder sonstiger mechanischer Belastung - keine Fremdstoffe zwischen die einzelnen Lagen gelangen können. Insbesondere soll das Eindringen von Feuchtigkeit in einen Bereich zwischen die einzelnen Lagen verhindert werden. Vorzugsweise ist die Displayeinheit so ausgebildet, dass sie Beschleunigungslasten von mehr als 5g beschädigungsfrei wiederstehen kann. Neben der Wahrung der eigenen strukturellen Integrität der Displayeinheit bezieht sich diese Anforderung vorzugsweise auch auf die Montageschicht, mit der die Displayeinheit innerhalb der Flugzeugkabine befestigt werden kann. Die Montageschicht soll in diesem Fall also die sichere Befestigung der Displayeinheit auch bei darauf einwirkenden Beschleunigungslasten von mehr als 5g gewährleisten.

Insbesondere im Falle eines Mehrlagen-Aufbaus der Displayeinheit ist bevorzugt, wenn die Displayeinheit derart ausgebildet ist, dass sie regelmäßige Luftdruckwechsel von Normaldruck auf Meereshöhe bis zu einem äquivalenten Druck bei wenigstens 2000 m Höhe beschädigungsfrei übersteht. Entsprechende Luftdruckwechsel treten in Kabinen von Passagierflugzeugen praktisch bei jedem Start und jeder Landung auf, weshalb die Displayeinheit diese Luftdruckwechsel vorzugsweise ohne Schäden überstehen soll. Bei einem Mehrlagen-Aufbau ist dafür bspw. sicherzustellen, dass keine flüssigen oder gasförmigen Bestandteile zwischen den einzelnen Lagen eingeschlossen sind und die einzelnen Lagen selbst ausreichend druckfest sind.

Die Steuerungseinheit kann eine, vorzugsweise gedruckte Antenne zum Empfang von Steuerungssignalen umfassen. Weiterhin können die Steuerungseinheit und/oder die Antenne zum Senden und Empfangen von Steuerungs- und Informationssignalen, vorzugsweise nach dem IEEE-802.11- und/oder Bluetooth-Low-Energy-Standard, ausgebildet sein. Über die Antenne kann die Steuerungseinheit drahtlos die auf der Displayfläche anzuzeigenden Informationen und sonstige Steuersignale erhalten. Die Übermittlung von anzuzeigenden Informationen und sonstigen Steuersignalen erfolgt vorzugsweise gesichert, bspw. mithilfe von Zertifikaten oder sonstiger bekannter Authentifikationsmechanismen. Ist die Displayeinheit berührungsempfindlich ausgestaltet, können über die Antenne die entsprechenden Berührungsinformationen in Form von Signale auch gesendet werden. Durch Verwendung eines Niedrigenergie-Funkstandards kann ein niedriger Verbrauch der Steuerungseinheit erreicht werden. Alternativ oder zusätzlich zu einer Drahtlosschnittstelle, kann die Steuerungseinheit auch eine drahtgebundene Schnittstelle, bspw. eine USB-Schnittstelle, oder eine Einrichtung zum Lesen und/oder Schreiben von Datenträgern, bspw. SD-Karten, aufweisen. Über entsprechende Schnittstellen bzw. Schreib- und/oder Leseeinrichtungen können Daten an die Steuerungseinheit übertragen oder aus dieser ausgelesen werden.

Der Energiespeicher kann bspw. eine gedruckte Batterie und/oder einen gedruckten Superkondensator umfassen.

Die Displayeinheit ist vorzugsweise flammhemmend ausgeführt. In anderen Worten soll die Displayeinheit also innerhalb von 15 Sekunden selbstlöschend sein, wenn sie einer Bunsenbrenner-Flamme für wenigstens 12 Sekunden ausgesetzt wird. Die Erfindung wird nun anhand einer vorteilhaften Ausführungsform unter Bezugnahme auf die beigefügten Zeichnungen beispielhaft beschrieben. Es zeigen:
- Figur 1:: ein erstes Ausführungsbeispiel einer erfindungsgemäßen Displayeinheit; und
- Figur 2a, b:: Schnittdarstellung durch die Displayeinheit gemäß Figur 1 in zwei Ausführungsvarianten.

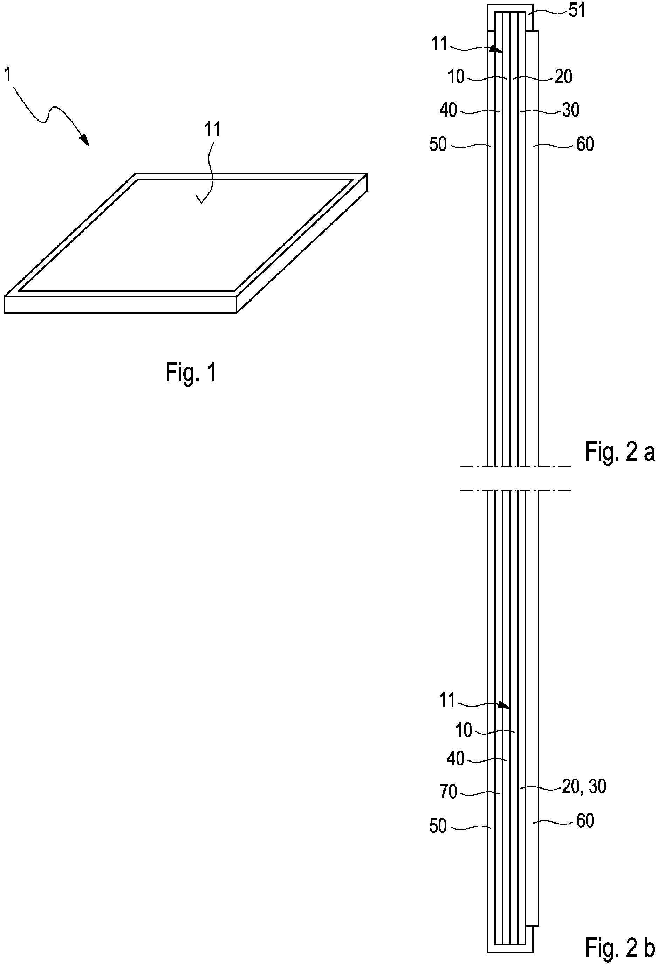

In Figur 1 ist ein erstes Ausführungsbeispiel einer erfindungsgemäßen energieautarken Displayeinheit 1 dargestellt. Die Displayeinheit 1 umfasst eine von außen einsehbare Displayfläche 11 eines Displayelements 10, auf der beliebige und insbesondere sich verändernde Informationen angezeigt werden können. Bei dem Displayelement 10 handelt es sich um ein E-Papier-Display, welches Informationen je nach Ausgestaltung monochrome oder farbig wiedergeben kann.

In Figur 2a,b ist der Aufbau der Displayeinheit 1 in zwei verschiedenen Ausführungsvarianten detaillierter dargestellt.

In der Ausführungsvariante gemäß Figur 2a ist das Displayelement 10 als Lage eines Mehrlagen-Aufbaus ausgebildet. Auf der Seite der Displayfläche 11 des Displayelementes 10 ist eine transparente Solarzelle 40 und eine transparente Schutzschicht 50 als weitere Lagen angeordnet. Sowohl die Solarzelle 40 als auch die Schutzschicht erstrecken sich über die gesamte Displayfläche 11 des Displayelementes 10. Aufgrund der transparenten Ausgestaltung der fraglichen Lagen 40, 50 bleiben die auf der Displayfläche 11 dargestellten Informationen aber weiterhin von außen sichtbar.

Auf der von der Displayfläche 11 abgewandten Seite des Displayelementes 10 sind zwei weitere Lagen vorgesehen, von denen die erste ein Energiespeicher 20 in Form einer gedruckten Batterie, die andere eine Steuerungseinrichtung 30 ist. Die Steuerungseinrichtung 30 ist als gedruckte Elektronik umfassend einen Microcontroller, eine Sende- und Empfangseinheit sowie eine Antenne zum Senden und Empfangen von Funksignalen gemäß dem Bluetooth-Low-Energie-Standard, ausgeführt.

Die äußerste Lage auf der von der Displayfläche 11 abgewandten Seite des Displayelementes 10 ist eine Montageschicht 60, die eine selbstklebende Außenseite aufweist. Mit der Montageschicht 60 kann das Displayelement 1 auf beliebigen Flächen befestigt werden. Um bei Bedarf auch auf gekrümmten Flächen angebracht werden zu können, ist das Displayelement 1 biegsam ausgestaltet, wozu sämtliche Lagen des Mehrlagen-Aufbaus grundsätzlich elastisch verformbar sind.

An der Außenkante des Displayelementes 1 ist umlaufend ein Schutzelement 51 vorgesehen, welches sämtliche Lagen des Displayelement 1 derart umgreift, dass kein Schmutz und keine Feuchtigkeit vom Rand her zwischen die einzelnen Lagen gelangen kann.

In Figur 2b ist eine alternative Ausführungsvariante des Displayelementes 1 dargestellt, wobei nachfolgend im Wesentlichen nur auf die Unterschiede dieser Ausführungsvariante eingegangen wird.

Bei dieser Ausführungsvariante sind Energiespeicher 20 und Steuerungseinrichtung 30 als eine einzelne, gemeinsame Lage in Form gedruckter Elektronik ausgebildet. Ein Teil der Lage ist dabei für den Energiespeicher 20, der andere Teil für die Steuerungseinrichtung 30 nebst Antenne vorgesehen.

Zwischen der Solarzelle 40 und der Schutzschicht 50 ist eine berührungsempfindliche Schicht 70 als weitere Lage vorgesehen. Damit die auf der Displayfläche 11 angezeigte Information weiterhin sichtbar bleibt, ist auch die berührungsempfindliche Schicht 70 transparent ausgeführt. Die berührungsempfindliche Schicht 70 arbeitet resistiv. Um Berührungen auf der Displayeinheit 1 registrieren zu können, ist die Schutzschicht 50 ausreichend flexibel, dass Berührungen des Displayelementes 1 an die berührungsempfindliche Schicht 70 übertragen werden.

Das Schutzelement 51 ist einstückig mit der Schutzschicht 50 ausgeführt. Die an sich transparente Schutzschicht 50 ist in den Bereichen abseits der Displayfläche 11, also insbesondere am Rand, eingefärbt, sodass sie in diesen Bereichen, die für die Sichtbarkeit der auf der Displayfläche 11 angezeigten Information nicht erheblich ist, intransparent ist.

Abgesehen von der Berührungsempfindlichkeit der Ausführungsvariante gemäß Figur 2b ist die Funktionsweise der Displayeinheiten 1 bei beiden Ausführungsvarianten identisch. Über die Solarzelle 40 wird einfallendes Sonnenlicht oder künstliches Licht einer Kabinenbeleuchtung in elektrische Energie gewandelt, die im Energiespeicher 20 gespeichert wird. Der Energiespeicher 20 versorgt sowohl die Steuerungseinheit 30 als auch das Displayelement 10 mit elektrischer Energie. Da das Displayelement 10 aufgrund seiner Ausgestaltung als E-Papier-Display praktisch nur bei Änderung der angezeigten Informationen Energie verbraucht und auch die Steuerungseinrichtung bspw. aufgrund der Verwendung des Bluetooth-Low-Energy-Funkstandards wenig Energie verbraucht, ist die Energieerzeugung durch die transparente Solarzelle 40 ausreichend, um den Energiespeicher 20 derart aufzuladen, dass das Displayelement 10 auch in Dunkelphasen - bspw. während der Nacht - zuverlässig betrieben werden kann.

Bei der Ausführungsvariante gemäß Figur 2b ist die Steuerungseinheit 30 weiterhin dazu ausgebildet, Berührungen auf der Displayfläche 11 über die berührungsempfindliche Schicht 70 zu detektieren. Entsprechende Berührungen können unmittelbar an einen externen Empfänger per Bluetooth-Low-Energy-Funkübertragung übermittelt oder durch die Steuerungseinrichtung 20 zunächst in Steuersignale gewandelt werden, die dann entsprechend übermittelt werden.

## Patentansprüche

1. Energieautarke Displayeinheit (1) für die Kabine von Fahrzeugen umfassend ein Displayelement (10) zur Anzeige von Informationen auf einer Displayfläche (11), ein Energiespeicher (20), eine Steuerungseinheit (30) und ein Photovoltaikelement, wobei das Photovoltaikelement zum Aufladen des Energiespeicher (20) mit dieser verbunden ist, der Energiespeicher (20) zur Energieversorgung mit dem Displayelement (10) und der Steuerungseinheit (30) verbunden ist und die Steuerungseinheit (20) zur Steuerung des Displayelementes (11) und der auf dessen Displayfläche (11) angezeigten Informationen ausgebildet ist,
**dadurch gekennzeichnet, dass**
das Photovoltaikelement eine sich über die gesamte Displayfläche (11) des Displayelements (10) erstreckende durchsichtige Solarzelle (40) ist, womit das Photovoltaikelement eine erste Lage auf dem Displayelement (10) ist.

2. Displayeinheit nach Anspruch 1,
**dadurch gekennzeichnet, dass**
das Displayelement (10) ein E-Papier-Display oder ein OLED-Display und somit eine weitere Lage eines Mehrlagen-Aufbaus der Displayeinheit (1) ist.

3. Displayeinheit nach einem der vorhergehenden Ansprüche,
**dadurch gekennzeichnet, dass**
der Energiespeicher (20) und/oder die Steuerungseinheit (30) jeweils als eine Lage oder zusammen als eine gemeinsame Lage eines Mehrlagen-Aufbaus der Displayeinheit (1) ausgebildet sind, wobei Energiespeicher (20) und/oder Steuerungseinheit (30) vorzugsweise wenigstens teilweise gedruckte Elektronikelemente umfassen.

4. Displayeinheit nach einem der vorhergehenden Ansprüche,
**dadurch gekennzeichnet, dass**
die auf der von der Displayfläche (11) abgewandten Seite äußerste Lage der Displayeinheit (1) eine Montageschicht (60) ist, die vorzugsweise eine selbstklebende oder magnetisch wirkende Oberfläche aufweist.

5. Displayeinheit nach einem der vorhergehenden Ansprüche,
**dadurch gekennzeichnet, dass**
die auf der Seite der Displayfläche (11) äußerste Lage der Displayeinheit (1) eine transparente Schutzschicht (50) zum Schutz der darunterliegenden Lagen vor Beschädigungen ist.

6. Displayeinheit nach einem der vorhergehenden Ansprüche,
**dadurch gekennzeichnet, dass**
die Displayeinheit (1) eine berührungsempfindliche Schicht (70)) zur Ermittlung einer Berührung des Displayfläche (11) umfasst, wobei die berührungsempfindliche Schicht (70) transparent und/oder die zwischen der berührungsempfindliche Schicht (70) und der Außenseite der Displayeinheit (1) auf der Seite der Displayfläche (11) angeordneten Schichten die Detektion von Berührungen durch die berührungsempfindliche Schicht (70) ermöglichen.

7. Displayeinheit nach einem der vorhergehenden Ansprüche,
**dadurch gekennzeichnet, dass**
die Displayeinheit (1) biegsam ist, wozu sämtliche Lagen der Displayeinheit (1) elastisch verformbar sind.

8. Displayeinheit nach einem der vorhergehenden Ansprüche,
**dadurch gekennzeichnet, dass**
die Lagen der Displayeinheit (1) an dem umlaufenden Rand derart miteinander verbunden oder dort mit einem zusätzlichen Element (51) versehen sind, dass keine Fremdstoffe zwischen die Lagen gelangen können.

9. Displayeinheit nach Anspruch 1 oder 2,
**dadurch gekennzeichnet, dass**
die Steuerungseinheit (30) eine, vorzugsweise gedruckte Antenne zum Empfang von Steuerungssignalen umfasst.

10. Displayeinheit nach Anspruch 3,
**dadurch gekennzeichnet, dass**
die Steuerungseinheit (30) und/oder die Antenne zum Senden und Empfangen von Steuerungs- und Informationssignalen, vorzugsweise nach dem IEEE-802.11- oder Bluetooth-Low-Energy-Standard, ausgebildet sind.

11. Displayeinheit nach Anspruch 4,
**dadurch gekennzeichnet, dass**
der Energiespeicher (20) eine gedruckte Batterie und/oder einen gedruckten Superkondensator umfasst.

12. Displayeinheit nach einem der vorhergehenden Ansprüche,
**dadurch gekennzeichnet, dass**
die Solarzelle und/oder der Energiespeicher so ausgelegt sind, dass über einen typischen Tageszyklus ausreichend Energie gewonnen und/oder gespeichert wird, dass der Betrieb der Displayeinheit über den gesamten Tag möglich ist, wobei vorzugsweise eine Änderung des Displayinhalts wenigstens einmal pro Stunde möglich ist.
